# NEUE EUROPÄISCHE PATENTSCHRIFT

(11) **EP 2 633 738 B2**
(45) Veröffentlichungstag und Bekanntmachung des Hinweises auf die Entscheidung über den Einspruch: **09.11.2022**
(45) Hinweis auf die Patenterteilung: 18.03.2015
(21) Anmeldenummer: 11772946.7
(22) Anmeldetag: 17.10.2011
(51) Int. Cl.: H05B 33/08, H05B 37/03, B60Q 11/00, B60R 16/023

(54) **VERBUND AUS EINEM BORDNETZSTEUERGERÄT UND WENIGSTENS EINEM LICHTSTEUERGERÄT EINES KRAFTFAHRZEUGS**
COMBINATION OF AN ON-BOARD POWER SUPPLY CONTROL DEVICE AND AT LEAST ONE LIGHT CONTROL DEVICE OF A MOTOR VEHICLE
ENSEMBLE COMPOSÉ D'UN APPAREIL DE COMMANDE DE RÉSEAU ÉLECTRIQUE DE BORD ET D'AU MOINS UN VARIATEUR D'ÉCLAIRAGE D'UN VÉHICULE AUTOMOBILE

(30) Priorität: 26.10.2010 DE 102010049716
(43) Veröffentlichungstag der Anmeldung: 04.09.2013
(73) Patentinhaber: Automotive Lighting Reutlingen GmbH, 72762 Reutlingen (DE)
(72) Erfinder: SCHNERR, Michael, 70565 Stuttgart (DE); BLUM, Dirk, 72076 Tübingen (DE)
(74) Vertreter: DREISS Patentanwälte PartG mbB
(86) Internationale Anmeldenummer: PCT/EP2011/068094
(87) Internationale Veröffentlichungsnummer: WO 2012/055718

(56) Entgegenhaltungen:
- EP-A1- 2 096 898
- DE-A1-102004 045 435
- DE-C1- 19 618 010
- GB-A- 2 434 929
- US-A1- 2003 226 954
- US-A1- 2005 200 287
- US-A1- 2006 061 303
- US-A1- 2006 232 394
- US-A1- 2007 159 118
- US-B1- 6 490 512

## Beschreibung

Die vorliegende Erfindung betrifft einen Verbund aus einem Bordnetzsteuergerät und wenigstens einem zum Betreiben wenigstens einer Halbleiterlichtquelle eingerichteten Lichtsteuergerät nach dem Oberbegriff des Anspruchs 1.

Ein solcher Verbund ist per se bekannt, wobei das Bordnetzsteuergerät dazu eingerichtet ist, das Lichtsteuergerät über eine an einen ersten Anschlusspin des Bordnetzsteuergeräts angeschlossene Versorgungsleitung mit Strom zu versorgen und über Anschlusspins des Bordnetzsteuergeräts fließende Ströme zu überwachen und zur Diagnose des an den jeweiligen Anschlusspin angeschlossenen Stromverbrauchers zu verwenden.

Ein Bordnetzsteuergerät kann als Stromverteilungszentrale in einem Kraftfahrzeug verstanden werden und ist dazu ausgelegt, Stromverbraucher im Kraftfahrzeug wie zum Beispiel eine Zentralverriegelung, ein Schiebedach, und Lichtquellen des Kraftfahrzeugs zu steuern und deren Funktion zu überwachen.

Bordnetzsteuergeräte sind Massenprodukte, die möglichst breit verwendbar sein sollen und ihre Funktion daher auch in Verbindung mit Verbrauchern erfüllen sollen, deren Eigenschaften voneinander abweichen. Beispiele von Verbrauchern mit unterschiedlichen Eigenschaften finden sich bei Lichtquellen, die zum Beispiel in Form von Glühlampen, Gasentladungslampen oder Halbleiterlichtquellen realisiert sein können. Unabhängig davon, ob ein Kraftfahrzeug zum Beispiel mit Halbleiterlichtquellen oder mit Glühlampen ausgerüstet wird, soll in beiden Fällen das gleiche Bordnetzsteuergerät verwendet werden können.

Glühlampen wie Halogenlampen und Halbleiterlichtquellen unterscheiden sich jedoch in der Art ihrer Ansteuerung. Glühlampen wie Halogenlampen werden mit einem kontinuierlich fließenden Betriebsstrom von etwa 4 bis 5 Ampere betrieben. Dagegen reicht für den Betrieb von Halbleiterlichtquellen, wie sie bei Kraftfahrzeugen eingesetzt werden, ein bedeutend geringerer Betriebsstrom von zum Beispiel 50 bis 100 mA aus. Darüber hinaus werden Halbleiterlichtquellen häufig nicht mit einem kontinuierlich fließenden Strom, sondern mit einem Pulsweiten-modulierten Strom betrieben.

Aus den genannten Unterschieden in der Ansteuerung ergeben sich Schwierigkeiten bei der Überwachung. Die Anschlusspins herkömmlicher Bordnetzsteuergeräte weisen jeweils einen High-Side-Schalter auf, also einen Schalter, der mit einer Eingangsseite an ein Versorgungspotenzial angeschlossen ist und der dazu eingerichtet ist, einen an seinem Ausgangsanschluss liegenden Verbraucher mit dem Versorgungspotenzial zu verbinden und/oder von dem Versorgungspotenzial zu trennen.

Zur Überwachung des über den High-Side-Schalter eines Anschlusspins fließenden Stroms weist das bekannte Bordnetzsteuergerät insbesondere eine Open Load Erkennungs-Funktion auf. In einem Open Load Zustand fließt kein Strom über den High Side Schalter, was zum Beispiel bei einem defekten Verbraucher der Fall sein kann. Zur Erkennung eines solchen Zustandes überprüft das Bordnetzsteuergerät, ob der über einen bestimmten Anschlusspin fließende Betriebsstrom kleiner als ein Schwellenwert von zum Beispiel 100 mA ist.

Da Glühlampen wie Halogenlampen mit einem kontinuierlich fließenden Betriebsstrom von etwa 4 bis 5 Ampere betrieben werden, erlaubt ein solcher Schwellenwert dem Bordnetzsteuergerät eine sichere Unterscheidung von defekten und funktionsfähigen Glühlampen.

Dies gilt jedoch nicht für Halbleiterlichtquellen, da deren normaler Betriebsstrom von zum Beispiel 50 bis 100 mA bereits viel näher an diesem Schwellenwert liegt. Problematisch ist auch, dass Halbleiterlichtquellen häufig nicht mit einem kontinuierlich fließenden Strom, sondern mit einem Pulsweiten-modulierten Strom betrieben werden. Für die reine Steuerungsfunktion könnte ein solcher Pulsweiten-modulierter Strom aus Strompausen und Phasen mit einer von Null abweichenden Stromstärke bestehen, wobei die Stromstärke oberhalb von dem genannten Schwellenwert liegt.

In der Strompause könnte die Stromstärke gleich Null sein oder so nahe bei Null liegen, dass sie zumindest kleiner als der genannte Schwellenwert ist. Wenn das Bordnetzsteuergerät den Betriebsstrom dann gerade in einer Strompause des Pulsweiten-modulierten Signals abtastet, könnte die niedrige Stromstärke der Strompause leicht als Fehler interpretiert werden, da derart niedrige Werte zum Beispiel auch bei einer Leitungsunterbrechung auftreten.

Um zu vermeiden, dass ein Bordnetzsteuergerät solche unrichtigen Fehlermeldungen erzeugt, hat man zum Betreiben von Halbleiterlichtquellen eingerichtete Lichtsteuergeräte, die an das Bordnetzsteuergerät angekoppelt sind, bisher mit Stromstärken versorgt, die für den Betrieb der Halbleiterlichtquellen unnötig groß sind. Man hat solche Lichtsteuergeräte vom Bordnetzsteuergerät insbesondere mit einem Strom speisen lassen, dessen Stromstärke auch in den Strompausen des PWM-Signals so hoch ist, dass die Stromüberwachungsfunktionen des Bordnetzsteuergerätes keine Schwellenwertunterschreitung registrieren.

Eine solche Mindeststromstärke liegt zum Beispiel bei einem Wert von 200 mA. Wie bereits erwähnt wurde, sind für den Betrieb einer Halbleiterlichtquelle, insbesondere einer Leuchtdiode; unter Umständen jedoch nur 50 bis 100 mA erforderlich. Die aus der resultierenden Differenz resultierende überschüssige Leistung wurde durch schaltungstechnische Maßnahmen im Lichtsteuergerät in Wärme umgewandelt. Dazu wurde insbesondere die von der Halbleiterlichtquelle in den Strompausen nicht benötigte Stromstärke innerhalb des Lichtsteuergerätes über eine Zusatzlast, zum Beispiel einen Ohmschen Widerstand, abgeleitet. Heuristisch ausgedrückt hat man damit dem Bordnetzsteuergerät vorgegaukelt, dass es eine Glühlampe betreiben würde.

Dieses Vorgehen hat Nachteile in der Form eines unnötig hohen Stromverbrauchs. Aus der Notwendigkeit, auch größere Wärmemengen abzuleiten, ergibt sich als weiterer Nachteil, dass mehr Kühlkörpermasse und Fläche erforderlich ist als dies bei besserer Energieeffizienz nötig wäre. Die an sich bessere Energieeffizienz der Halbleiterlichtquelle wird damit zumindest teilweise wieder eingebüßt.

Vor diesem Hintergrund besteht die Aufgabe der Erfindung darin, einen Verbund aus einem Bordnetzsteuergerät und wenigstens einem Lichtsteuergerät der eingangs genannten Art anzugeben, der die genannten Nachteile nicht oder nur in einem deutlich verringerten Umfang aufweist.

Diese Aufgabe wird mit den Merkmalen des Anspruchs 1 gelöst.

Die Erfindung zeichnet sich demnach dadurch aus, dass das Lichtsteuergerät zusätzlich über eine Fehlerleitung an einen weiteren Anschlusspin des Bordnetzsteuergeräts angeschlossen ist und dazu eingerichtet ist, die Funktion der angeschlossenen Halbleiterlichtquelle zu überprüfen und im Fall einer Fehlfunktion einen Stromfluss in der Fehlerleitung aufzusteuern, und wobei das Bordnetzsteuergerät dazu eingerichtet ist, auf den aufgesteuerten Stromfluss mit der Erzeugung einer Fehlermeldung zu reagieren.

Die Überwachung der Lichtquelle, die bei einer Glühlampe als Lichtquelle allein durch das Bordnetzsteuergerät erfolgte, wird bei der Erfindung auf die Lichtsteuergeräte und das Bordnetzsteuergerät verteilt. Die eigentliche Fehlererkennung erfolgt durch das Lichtsteuergerät. Die Erfindung erlaubt eine stromsparende Übermittlung einer Fehlermeldung vom betroffenen Lichtsteuergerät an das Bordnetzsteuergerät, bei der sowieso vorhandene Hardware-Strukturen (nämlich Standardanschlusspins mit ihrer internen Beschaltung) des Bordnetzsteuergerätes für die Auswertung und Interpretation der Fehlermeldung genutzt werden.

Damit sind Hardware-mäßig gleiche Bordnetzsteuergeräte, die sich nur in ihrer Software unterscheiden, sowohl für den Betrieb von Glühlampen als auch für einen Energie-effizienten Betrieb von Halbleiterlichtquellen geeignet.

Im Gegensatz zu dem eingangs genannten Stand der Technik, bei dem im regulären Betrieb der Halbleiterlichtquellen ein Anteil des über den zugehörigen Anschlusspin des Bordnetzsteuergerätes fließenden Stroms über eine Zusatzlast in Wärme umgewandelt werden musste, erlaubt die Erfindung einen Betrieb der Halbleiterlichtquellen, bei dem über den zugehörigen Anschlusspin des Bordnetzsteuergerätes nur der Strom fließt, der tatsächlich für den Betrieb der Halbleiterlichtquelle erforderlich ist. Ein Zusatzlast ist nicht erforderlich. Im Fehlerfall fließt nur ein vergleichsweise geringer Strom über den Anschlusspin der Fehlerleitung.

Auf diese Weise wird ein Betrieb und eine Überwachung der Halbleiterlichtquelle unter Verwendung der normalen Überwachung des Stromflusses über Anschlusspins des Bordnetzsteuergeräts möglich. Dabei muss die Hardware bekannter Bordnetzsteuergeräte nicht verändert werden. Es ist lediglich erforderlich pro Lichtsteuergerät einen zusätzlichen Anschlusspin des Bordnetzsteuergeräts zu belegen. Dies ist jedoch unproblematisch, weil herkömmliche Bordnetzsteuergeräte ausreichend viele ungenutzte Anschlusspins aufweisen und darüber hinaus dazu eingerichtet sind, die Stromflüsse über diese Anschlusspins zu überwachen.

Dabei können bisher verwendete im Lichtsteuergerät erforderliche elektrische Zusatzlasten, an denen bisher überschüssige elektrische Leistung in Wärme umgewandelt wurde, weggelassen werden, Damit können auch die bisher zur Abführung der zusätzlichen Wärme erforderlichen zusätzlichen Strukturen weggelassen werden. Damit kann Bauraum und Gewicht eingespart werden, dass bisher für größere Kühlstrukturen bereit gestellt werden musste. Ein an sich unnötiger Stromfluss in der Höhe der oben genannten 200 mA erzeugt bei einer typischen Bordnetzspannung von 16 V eine elektrische Leistung von 3,2 W, die beim Stand der Technik in Wärme umgewandelt werden muss. Durch den Wegfall dieser Wärme erlaubt die Erfindung unter Umständen das Ersetzen eines gut Wärme abführenden Metallgehäuses des Lichtsteuergeräts durch ein leichteres und kostengünstigeres Kunststoffgehäuse. Dadurch lassen sich auch die Herstellungskosten verringern.

Weitere Vorteile ergeben sich aus den abhängigen Ansprüchen, der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen. Zeichnungen

Ausführungsbeispiele der Erfindung sind in den Zeichnungen dargestellt und werden in der nachfolgenden Beschreibung näher erläutert. Dabei zeigen, jeweils in schematischer Form:
Figur 1 ein erstes Ausführungsbeispiel der Erfindung; und
Figur 2 ein zweites Ausführungsbeispiel der Erfindung.

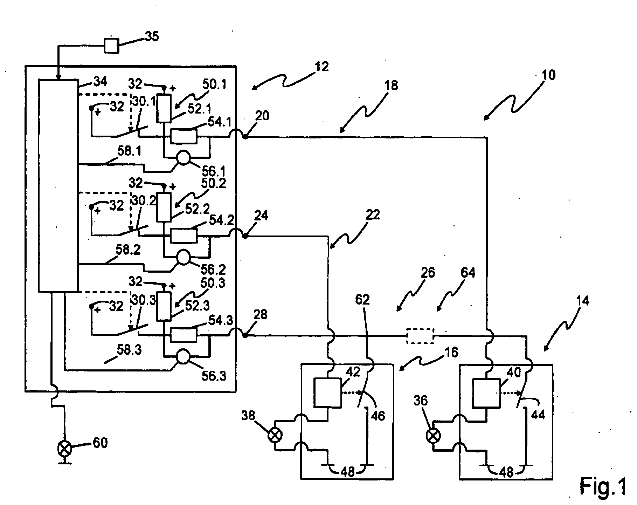

Dabei bezeichnen gleiche Bezugszeichen in den Figuren jeweils gleiche oder zumindest ihrer Funktion nach gleiche Elemente. Im Einzelnen zeigt die Figur 1 einen Verbund aus einem Bordnetzsteuergerät 12, einem ersten Lichtsteuergerät 14 und einem zweiten Lichtsteuergerät 16. Das Bordnetzsteuergerät 12 und die daran angeschlossenen Verbraucher und/oder Steuergeräte sind im Allgemeinen an verschiedenen Orten im Kraftfahrzeug angeordnet und über Leitungen miteinander verbunden. Das erste Lichtsteuergerät 14 ist über eine erste Versorgungsleitung 18 an einen ersten Anschlusspin 20 des Bordnetzsteuergeräts 12 angeschlossen. Das zweite Lichtsteuergerät 16 ist über eine zweite Versorgungsleitung 22 an einen zweiten Anschlusspin 24 des Bordnetzsteuergerätes 12 angeschlossen. Darüber hinaus sind beide Lichtsteuergeräte über eine gemeinsame Fehlerleitung 26 an einen dritten Anschlusspin 28 des Bordnetzsteuergerätes 12 angeschlossen.

Die Anschlusspins 20, 24, 28 sind über Anschlusspin-individuelle Schalter mit einem internen Versorgungspotenzialanschluss 32 des Bordnetzsteuergerätes 12 verbunden. An dem Versorgungspotenzialanschluss 32 liegt zum Beispiel die Bordnetzspannung des Kraftfahrzeugs an, wenn dessen Zündung eingeschaltet ist. Der erste Anschlusspin 20 ist über einen ersten Schalter 30.1 mit dem Versorgungspotenzialanschluss 32 verbunden, während der zweite Anschlusspin 24 über einen zweiten Schalter 30.2 und der dritte Anschlusspin 28 über einen dritten Schalter 30.3 mit dem Versorgungspotenzialanschluss 32 verbunden ist. Aufgrund der Verbindung mit dem Versorgungspotenzialanschluss 32 handelt es sich bei den Schaltern 30.1, 30.2 und 30.3 um sogenannte High-Side-Schalter.

Die Schalter 30.1, 30.2 und 30.3 werden von einer Steuerschaltung 34 gesteuert. Die Steuerschaltung 34 weist dazu bevorzugt einen Mikroprozessor und einen Speicher auf und steuert die Schalter 30.1, 30.2 und 30.3 durch Abarbeitung eines in dem Speicher abgelegten Programms. Die Programmabarbeitung wird insbesondere auch durch von außen eingehende Steuerbefehle gesteuert. In der Figur 1 wird dies durch einen Lichtschalter 35 repräsentiert, dessen Betätigung durch einen Fahrer des Kraftfahrzeugs ein Einschaltsignal auslöst, das vom Lichtschalter 35 an die Steuerschaltung 34 übergeben wird. Die Steuerschaltung 34 ist dazu eingerichtet, insbesondere dazu programmiert, die Schalter 30.1, 30.2 und 30.3 dann so zu steuern, dass die angeschlossenen Lichtsteuergeräte 14 und 16 mit Strom versorgt werden.

In der Ausgestaltung, die in der Figur 1 dargestellt ist, steuert jedes Lichtsteuergerät 14, 16 wenigstens eine Halbleiterlichtquelle 36, 38. Jeder Halbleiterlichtquelle 36, 38 besteht dabei in einer Ausgestaltung aus einer oder mehreren Leuchtdioden. Für die Steuerung der Halbleiterlichtquellen 36, 38 weist jedes Lichtsteuergerät 14, 16 eine Schutz- und Überwachungsschaltung 40, 42 auf. Jede Schutz- und Überwachungsschaltung 40, 42 ist insbesondere dazu eingerichtet, Fehlfunktionen der jeweils angeschlossenen Halbleiterlichtquelle 36, 38 zu erkennen und/oder einen Temperatur-Schutz zu gewährleisten und/oder eine elektromagnetische Verträglichkeit und/oder einen Verpolschutz zu gewährleisten.

Darüber hinaus ist die Schutz- und Überwachungsschaltung 40 dazu eingerichtet, bei einer erkannten Fehlfunktion einen normalerweise offenen Schalter 44 zu schließen, mit dem die Fehlerleitung 26 bei geschlossenem Schalter 44 mit einem Masseanschluss 48 verbunden wird. Analog ist die Schutz- und Überwachungsschaltungen 42 dazu eingerichtet, bei einer erkannten Fehlfunktion einen normalerweise offenen Schalter 46 zu schließen, mit dem die Fehlerleitung 26 bei geschlossenem Schalter 46 mit einem Masseanschluss 48 verbunden wird.

Typische Fehlfunktionen sind zum Beispiel ein Kurzschluss einer angeschlossenen Halbleiterlichtquelle 36, 38, eine Leitungsunterbrechung oder eine Übertemperatur der angeschlossenen Halbleiterlichtquelle 36, 38.

Durch ein Schließen des Schalters 44 des ersten Lichtsteuergerätes 14 und/oder durch ein Schließen des Schalters 46 des zweiten Lichtsteuergerätes 16 wird der dritte Anschlusspin 28, an den die gemeinsame Fehlerleitung 26 angeschlossen ist, niederohmig mit der Masse 48 verbunden, wobei die genannte Verbindung vorher hochohmig war. Dieser Zustandswechsel wird mit einer an sich bekannten Open-Load-Erkennungsfunktion des Bordnetzsteuergerätes 12 detektiert. Zu Erkennung eines Open-Load-Zustands sind Verbindungen der High-Side-Schalter 30.1, 30.2 und 30.3 mit den jeweils zugehörigen Anschlusspins 20, 24, 28 mit jeweils einer Open-Load-Erkennungsschaltung ausgestattet.

Eine erste Open-Load-Erkennungsschaltung 50.1 des ersten Anschlusspins 20 weist einen Pull-Up-Widerstand 52.1 einen Messwiderstand 54.1 und einen Spannungsmesser 56.1 auf. Der Pull-Up-Widerstand 52.1 liegt zusammen mit dem Messwiderstand 54.1 in Reihe zwischen dem Versorgungspotenzialanschluss 32 und dem ersten Anschlusspin 20. Dabei liegt der Pull-Up-Widerstand am Versorgungspotenzialanschluss 32. Ein Mittelabgriff der Reihenschaltung führt auf den ersten Schalter 30.1. Der Spannungsmesser 56.1 ist parallel zum Messwiderstand 54.1 geschaltet und dazu eingerichtet, gemessene Spannungswerte über eine Leitung 58.1 an die Steuerschaltung 34 zu übergeben.

Der zweite Anschlusspin 24 weist eine zweite Open-Load-Erkennungsschaltung 50.2 auf. Der dritte Anschlusspin 28 weist eine dritte Open-Load-Erkennungsschaltung 50.3 auf. Die zweite Open-Load-Erkennungsschaltung 50.2 und die dritte Open-Load-Erkennungsschaltung 50.3 sind genauso aufgebaut wie die erste Open-Load-Erkennungsschaltung 50.1.

So weist die zweite Open-Load-Erkennungsschaltung einen Pull-Up-Widerstand 52.2, einen Messwiderstand 54.2 und einen Spannungsmesser 56.2 mit einer Leitung 58.2 zur Steuerschaltung 34 auf. Analog weist die dritte Open-Load-Erkennungsschaltung 50.3 einen Pull-Up-Widerstand 52.3, einen Messwiderstand 54.3 und einen Spannungsmesser 56.3 mit einer Leitung 58.3 zur Steuerschaltung 34 auf.

Für eine Erläuterung der üblichen Open-Load-Erkennung wird im Folgenden zunächst angenommen, dass an den ersten Anschlusspin 20 eine Glühlampe angeschlossen ist. Eine solche Glühlampe besitzt im funktionsfähigen Zustand einen vergleichsweise niedrigen Widerstand: Sie ist niederohmig. Bei geschlossenem Schalter 30.1 fließt dann ein Strom. Bei durchgebranntem Glühfaden besitzt die Lampe jedoch einen großen Widerstand: Sie ist hochohmig und lässt keinen Stromfluss zu. In diesem Fall wäre der erste Anschlusspin 20 auch bei geschlossenem ersten Schalter 30.1 stromlos und damit in einem Open-Load-Zustand.

Die Detektion eines Open-Load-Zustandes ist damit gleichbedeutend mit der Detektion einer hochohmigen Verbindung des ersten Anschlusspins 20 zur Masse 48, was bei einer an den ersten Anschlusspin 20 angeschlossenen Glühlampe insbesondere bei einem durchgebrannten Glühfaden vorkommt. Die Erkennung eines Open-Load-Zustandes ist damit in diesem Umfeld gleichbedeutend mit der Erkennung eines Fehlerzustandes.

Um einen funktionsfähigen Zustand von einem Fehlerzustand zu unterscheiden, öffnet die Steuerschaltung 34 den ersten Schalter 30.1. Am internen Versorgungspotenzialanschluss 32 liegt die Bordnetzspannung an. Bei niederohmiger Glühlampe fließt dann ein Strom durch den Pull-Up-Widerstand 52.1, den Messwiderstand 54.1 und die Glühlampe, die unter der oben angenommenen Voraussetzung an den ersten Anschlusspin 20 angeschlossen ist. Der Spannungsmesser 56.1 erfasst den Spannungsabfall über dem Messwiderstand 54.1 und übergibt ihn zur Auswertung an die Steuerschaltung 34. Ein vergleichsweise großer Spannungsabfall ergibt sich bei niederohmiger Glühlampe und daher vergleichsweise großem Stromfluss. Bei durchgebrannter Glühlampe ergibt sich dagegen kein Stromfluss durch den Messwiderstand 54.1 und damit auch kein Spannungsabfall am Messwiderstand 54.1. Dieser Open-Load-Zustand wird von der bekannten Steuerschaltung 34 als Fehler gewertet.

Bei dem bekannten Verbund aus einem Bordnetzsteuergerät und einem Lichtsteuergerät wird durch ein entsprechend eingerichtetes Lichtsteuergerät immer so viel Strom aus dem zugehörigen Anschlusspin des Bordnetzsteuergeräts gezogen, das die beschriebene Open-Load-Erkennung, die auf einer Überwachung des Stromflusses in der Versorgungsleitung basiert, nicht anspricht.

Im Gegensatz dazu basiert die Fehlererkennung bei der hier vorgestellten Erfindung nicht mehr auf einer Überwachung des Stromflusses in der Versorgungsleitung. Die Erfindung zeichnet sich vielmehr dadurch aus, dass das Lichtsteuergerät zusätzlich über eine Fehlerleitung an einen weiteren Anschlusspin des Bordnetzsteuergeräts angeschlossen ist und dazu eingerichtet ist, die Funktion der angeschlossenen Halbleiterlichtquelle zu überprüfen und im Falle einer Fehlfunktion einen Stromfluss in der Fehlerleitung aufzusteuem. Darüber hinaus ist das Bordnetzsteuergerät dazu eingerichtet, auf den aufgesteuerten Stromfluss mit der Erzeugung einer Fehlermeldung zu reagieren.

Im Folgenden sei angenommen, dass beide Halbleiterlichtquellen 36 und 38 funktionsfähig sind. Dann halten die Schutz- und Überwachungsschaltungen 40 und 42 die Schalter 44 und 46 offen. Es fließt kein Strom durch den Pull-Up-Widerstand 52.3, den Messwiderstand 54.3 und die Fehlerleitung 28. Die bereits beschriebene Open-Load-Erkennung erkennt dann einen Open-Load-Zustand am Anschlusspin 28. Anders als beim bekannten Bordnetzsteuergerät ist das Bordnetzsteuergerät 12 des erfindungsgemäßen Verbundes aus einem Bordnetzsteuergerät 12 und wenigstens einem Lichtsteuergerät 14, 16 dazu eingerichtet, den detektierten Open-Load-Zustand am Anschlusspin 28 der Fehlerleitung 26 nicht als Fehler, sondern als funktionsfähigen Zustand zu werten.

Die Fehlererkennung und Signalisierung erfolgt bei der Erfindung durch ein Zusammenwirken des wenigstens einen Lichtsteuergerätes 14, 16 mit dem Bordnetzsteuergerät 12. Dabei ist die bekannte, auf einer Überwachung des Stroms in der Versorgungsleitung basierende Fehlererkennung im Bordnetzsteuergerät 12 abgeschaltet. Die eigentliche Feststellung, dass ein Fehler vorliegt, erfolgt durch die Schutz- und Überwachungsschaltung 40 oder 42.

Im Folgenden sei zunächst angenommen, dass ein Fehler der Halbleiterlichtquelle 36 auftritt und von der Schutz- und Überwachungsschaltung 40 des ersten Lichtsteuergerätes 14 festgestellt wird. Die Schutz- und Überwachungsschaltung 40 ist dazu eingerichtet, in diesem Fehlerfall den Schalter 44 zu schließen. Der Schalter 44 ist in einer Ausgestaltung eine Open-Collector-Schaltung eines Bipolartransistors oder, in einer anderen Ausgestaltung eine Open-Drain-Schaltung eines Feldeffekttransistors. Dann wird die Standard-Open-Load-Erkennung für den Anschlusspin 28 dazu verwendet, diesen Fehler mit einem relativ niedrigen Strom an das Bordnetzsteuergerät 12 zu signalisieren.

Dabei ist der dem Anschlusspin 28 im Bordnetzsteuergerät 12 zugeordnete High-Side-Schalter 30.3 dauerhaft offen. Er wird für die Erfindung nicht gebraucht und ist nur deshalb dargestellt, weil er zur internen Standardbeschaltung eines Standardanschlusspins 28 des Bordnetzsteuergerätes 12 gehört.

Bevor der Fehler aufgetreten ist, und die Schutz- und Überwachungsschaltung 40 des ersten Lichtsteuergeräts 14 den Schalter 44 geschlossen hat, hat die Standard-Open-Load-Erkennung, die vom Bordnetzsteuergerät 12 für den Anschlusspin 28 durchgeführt wird, einen Open-Load-Zustand des Anschlusspins 28 der Fehlerleitung 26 detektiert.

Anders als beim Stand der Technik wird dieser Open-Load-Zustand vom Bordnetzsteuergerät 12 des erfindungsgemäßen Verbundes aber nicht als Fehler interpretiert. Das Schließen des Schalters 44 beendet den Open-Load-Zustand, weil es einen Stromfluss über den Pull-Up-Widerstand 52.3, den Messwiderstand 54.3, die Fehlerleitung 26 und den geschlossenen Schalter 44 nach Masse 48 ermöglicht. Der von diesem Strom erzeugte Spannungsabfall am Messwiderstand 54.3 wird vom Spannungsmesser 56.3 detektiert und der Steuerschaltung 34 des Bordnetzsteuergeräts 12 übergeben.

Das Bordnetzsteuergerät 12 ist dazu eingerichtet, insbesondere dazu programmiert, diesen Spannungsabfall als Fehler von einem der an die gemeinsame Fehlerleitung 26 angeschlossenen Verbraucher zu werten und ein entsprechendes Fehlersignal auszugeben und/oder abzuspeichern. Die Ausgabe kann zum Beispiel durch Einschalten einer Fehlerlampe 60 oder durch eine Anzeige auf einem Bildschirm eines Fahrzeug-Infotainment-Systems erfolgen, die sich im Sichtfeld des Fahrers des Kraftfahrzeugs befindet. Alternativ oder ergänzend wird die Fehlermeldung in einem auslesbaren Speicher für eine spätere Verwendung durch Werkstattpersonal abgespeichert.

In der Ausgestaltung, die in der Figur 1 dargestellt ist, sind zwei Lichtsteuergeräte 14 und 16 an eine gemeinsame Fehlerleitung 26 angeschlossen. Mit Hilfe der beschriebenen Open-Load-Erkennungsfunktion für den Anschlusspin 28 kann dem Bordnetzsteuergerät 12 signalisiert werden, dass eines der beiden Steuergeräte 14 oder 16 defekt ist. Das Bordnetzsteuergerät 12 ist dann aber nicht ohne weiteres in der Lage, zu unterscheiden ob das erste Lichtsteuergerät 14 oder das zweite Lichtsteuergerät 16 defekt ist.

Um eine solche Unterscheidung zu ermöglichen sieht eine weitere Ausgestaltung vor, dass die Steuerschaltung 34 die an einer gemeinsamen Fehlerleitung 26 angeschlossenen Lichtsteuergeräte 14 und 16 hintereinander kurzzeitig abschaltet.

Das Abschalten des ersten Lichtsteuergerätes 14 erfolgt dadurch, dass die Steuerschaltung 34 den ersten High-Side-Schalter 30.1 öffnet. Das erste Lichtsteuergerät 14 ist dazu eingerichtet, im abgeschalteten Zustand den Schalter 44 zu öffnen oder offen zu halten. Wenn die beschriebene Open-Load-Erkennung des Anschlusspins 28 auf ein Schließen des Schalters 30.1 in der Versorgungsleitung 18 für das erste Lichtsteuergerät 14 damit regiert, dass die Open-Load-Erkennung wieder einen Open-Load-Zustand feststellt, so bedeutet dies, dass das Lichtsteuergerät 14 das defekte Steuergerät ist.

Reagiert die Open-Load-Erkennung für den Anschlusspin 28 dagegen nicht auf ein Öffnen des ersten High-Side-Schalters 30.1, wird dieser wieder geschlossen und das erste Lichtsteuergerät 14 wieder eingeschaltet. Es steht dann fest, dass das erste Lichtsteuergerät 14 nicht das fehlerhafte Steuergerät ist.

Wenn nur zwei Lichtsteuergeräte, oder allgemeiner, nur zwei Verbraucher vorhanden sind, die an der gemeinsamen Fehlerleitung 26 hängen, steht dann bereits fest, dass der zweite Verbraucher fehlerhaft ist. Sind mehr als zwei Lichtsteuergeräte oder allgemeiner, mehr als zwei Verbraucher, an eine gemeinsame Fehlerleitung 26 angeschlossen, werden diese Verbraucher einzeln nacheinander abgeschaltet und wieder eingeschaltet, bis das fehlerhafte Steuergerät, beziehungsweise der fehlerhafte Verbraucher, identifiziert ist.

Eine weitere Ausgestaltung sieht vor, dass auf jeden Fall alle Verbraucher nacheinander abgeschaltet und wieder eingeschaltet werden, sodass jeweils nur ein einzelner Verbraucher abgeschaltet ist, um auch solche Fehlerzustände zu detektieren, bei denen mehr als ein Verbraucher fehlerhaft ist. Das Bordnetzsteuergerät 12 ist dazu eingerichtet, insbesondere dazu programmiert, nach der Identifikation des defekten Verbrauchers oder der defekten Verbraucher eine diesen speziellen Fehlerzustand charakterisierende Fehlermeldung abzuspeichern oder anzuzeigen, wobei die Anzeige zum Beispiel auf einem Bildschirm eines Fahrzeug-Infotainment-Systems erfolgen kann.

Eine weitere Ausgestaltung basiert auf dem Umstand, dass bei einem Fehler des ersten Lichtsteuergerätes 14 ein Stromfluss zwischen dem Versorgungspotenzialanschluss 32 der dritten Open-Load-Erkennungsschaltung 50.3 und dem Masseanschluss 48 des ersten Lichtsteuergeräts 14 erzeugt wird, während bei einem Fehler des zweiten Lichtsteuergerätes 16 ein Stromfluss zwischen dem genannten Versorgungspotenzialanschluss 32 und dem Masseanschluss 48 des zweiten Lichtsteuergerätes 16 hervorgerufen wird. Das heißt insbesondere, dass der zwischen dem Anschluss 62 des zweiten Lichtsteuergeräts 16 an die gemeinsame Fehlerleitung 26 und den Masseanschluss 48 des ersten Lichtsteuergerätes 14 liegende Strompfad nur bei geschlossenem Schalter 44, also bei einem Fehler des ersten Lichtsteuergeräts 14 einen Strom führt.

Ein optional vorhandener weiterer Widerstand 64, der zwischen dem Anschluss 62 und dem Masseanschluss 48 des ersten Lichtsteuergeräts 14 angeordnet ist, liegt dann in Reihe mit dem Pull-Up-Widerstand 52.3 und dem Messwiderstand 54.3 und entfaltet eine zusätzlich strombegrenzende Funktion. Als Folge fließt bei einem Fehler des ersten Lichtsteuergeräts 14 ein kleinerer Strom in der gemeinsamen Fehlerleitung 26 als bei einem Fehler des zweiten Lichtsteuergeräts 16.

Diese unterschiedlichen Ströme rufen unterschiedliche Spannungsabfälle über dem Messwiderstand 54.3 hervor und erlauben der Steuerschaltung 34 eine direkte Zuordnung einer vom Spannungsmesser 56.3 erfassten Spannung zu einem Fehler des ersten Lichtsteuergeräts 14 oder des zweiten Lichtsteuergeräts 16.

Alternativ könnte ein solcher weiterer Widerstand 64 auch zwischen dem Anschluss 62 des zweiten Lichtsteuergerätes an die gemeinsame Fehlerleitung 26 und dem Masseanschluss 48 des zweiten Lichtsteuergeräts 16 liegen. Wesentlich für die Unterscheidung ist lediglich, dass der Widerstand des Strompfades, der zwischen dem Masseanschluss 48 des ersten Lichtsteuergerätes 14 und dem Anschluss 62 des zweiten Lichtsteuergerätes 16 liegt, einen anderen Wert besitzt als der Widerstand des Strompfades, der zwischen dem Masseanschluss 48 des zweiten Lichtsteuergerätes und dem Anschluss 62 des zweiten Lichtsteuergerätes an die gemeinsame Fehlerleitung 26 liegt.

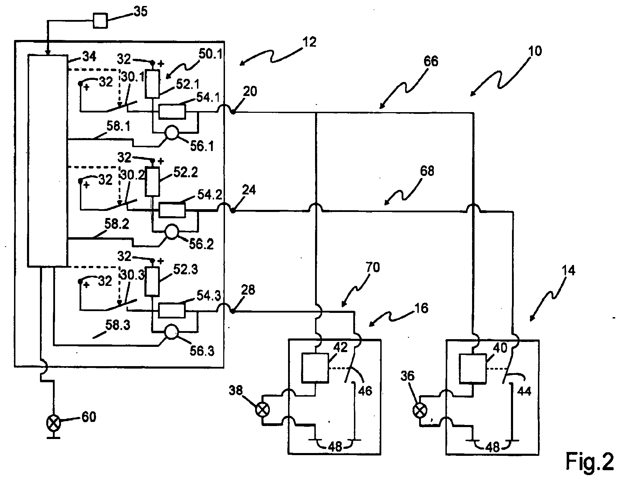

Figur 2 zeigt eine alternative Ausgestaltung, bei der das erste Lichtsteuergerät 14 und zweite Lichtsteuergerät 16 zusammen über eine gemeinsame Versorgungsleitung 66 an einen ersten Anschlusspin 20 des Bordnetzsteuergeräts 12 angeschlossen sind. Darüber hinaus ist das erste Lichtsteuergerät 14 über eine eigene Fehlerleitung 68 an einen zweiten Anschlusspin 24 des Bordnetzsteuergeräts 12 angeschlossen. Auch das zweite Lichtsteuergerät 16 ist über eine eigene Fehlerleitung 70 an einen dritten Anschluss 28 des Bordnetzsteuergeräts 12 angeschlossen.

Die beiden Anschlüsse 24 und 28 des Bordnetzsteuergeräts 12 werden dabei zusammen mit ihren zugehörigen High-Side-Schaltern 30.2 und 30.3 sowie ihren jeweils zugehörigen Open-Load-Erkennungsschaltungen 50.2 und 50.3 so betrieben, wie es im Zusammenhang mit der Figur 1 für den dritten Anschluss 28 und dessen zugehörigen High-Side-Schalter 30.3 sowie dessen zugehöriger Open-Load-Erkennungsschaltung 50.3 beschrieben worden ist.

Der erste Anschlusspin 20 und seine zugehörige interne Beschaltung mit dem High-Side-Schalter 30.1 und der Open-Load-Erkennungsschaltung 50.1 wird so betrieben, wie es im Zusammenhang mit der Figur 1 für die beiden Anschlusspins 20 und 24 mit ihren jeweils zugehörigen internen Beschaltungen mit High-Side-Schaltern 30.1 und 30.2 sowie Open-Load-Erkennungsschaltungen 50.1 und 50.2 beschrieben worden ist.

Ein Unterschied zwischen den Gegenständen der Figur 1 und der Figur 2 ergibt sich daraus, dass die separaten Fehlerleitungen der Lichtsteuergeräte 14 und 16 beim Gegenstand der Figur 2 eine direkte Zuordnung eines erkannten Fehlers zu dem jeweils betroffenen Lichtsteuergerät 14 oder 16 erlauben, so dass ein sukzessives Ein- und Ausschalten der Lichtsteuergeräte 14 und 16 zur weiteren Identifizierung des betroffenen Steuergeräts 14 oder 16 nicht erforderlich ist.

Die Erfindung wurde unter Bezug auf einen Verbund eines Bordnetzsteuergerätes mit zwei Lichtsteuergeräten erläutert. Es versteht sich aber, dass die Erfindung nicht auf einen Verbund beschränkt ist, der zwei Lichtsteuergeräte enthält sondern in Verbünden mit einer beliebigen Zahl größer oder gleiche Eins von Lichtsteuergeräten verwendbar ist, wobei gleichzeitig weitere Verbraucher wie Schiebedachantriebe, Fensterheber und dergleichen an weitere Anschlusspins des Bordnetzsteuergerätes angeschlossen sein können.

## Patentansprüche

1. Verbund (10) aus einem Bordnetzsteuergerät (12) und wenigstens einem zum Betreiben wenigstens einer Halbleiterlichtquelle (36, 38) eingerichteten Lichtsteuergerät (14), wobei das Bordnetzsteuergerät (12) dazu eingerichtet ist, das Lichtsteuergerät (14) über eine an einen ersten Anschlusspin (20) des Bordnetzsteuergeräts (12) angeschlossene Versorgungsleitung (18) mit Strom zu versorgen und über Anschlusspins des Bordnetzsteuergeräts (12) fließende Ströme zu überwachen und zur Diagnose des an den jeweiligen Anschlusspin angeschlossenen Stromverbrauchers zu verwenden, **dadurch gekennzeichnet, dass** das Lichtsteuergerät (14) zusätzlich über eine Fehlerleitung (26) an einen weiteren Anschlusspin (28) des Bordnetzsteuergeräts (12) angeschlossen ist und dazu eingerichtet ist, die Funktion der angeschlossenen Halbleiterlichtquelle (14) zu überprüfen -und im Fall einer Fehlfunktion einen Stromfluss in der Fehlerleitung (26) aufzusteuern, und wobei das Bordnetzsteuergerät (12) dazu eingerichtet ist, auf den aufgesteuerten Stromfluss mit der Erzeugung einer Fehlermeldung zu reagieren.

2. Verbund (10) nach Anspruch 1, **dadurch gekennzeichnet, dass** jedes Lichtsteuergerät (14, 16) dazu eingerichtet ist, wenigstens eine Halbleiterlichtquelle (36, 38) zu steuern.

3. Verbund (10) nach einem der vorhergehenden Ansprüche, **dadurch gekennzeichnet, dass** jedes Lichtsteuergerät (14, 16) eine Schutz- und Überwachungsschaltung (40, 42) aufweist, die dazu eingerichtet ist, Fehlfunktionen der jeweils angeschlossenen Halbleiterlichtquelle (36, 38) zu erkennen und/oder einen Temperatur-Schutz zu gewährleisten und/oder eine elektromagnetische Verträglichkeit und/oder einen Verpolschutz zu gewährleisten.

4. Verbund (10) nach Anspruch 3, **dadurch gekennzeichnet, dass** die Schutz- und Überwachungsschaltung (40) dazu eingerichtet ist, bei einer erkannten Fehlfunktion einen normalerweise offenen Schalter (44) zu schließen, mit dem die Fehlerleitung (26) bei geschlossenem Schalter (44) mit einem Masseanschluss (48) verbunden wird.

5. Verbund (10) nach einem der vorhergehenden Ansprüche, **dadurch gekennzeichnet, dass** das Bordnetzsteuergerät (12) dazu eingerichtet, insbesondere dazu programmiert ist, einen Stromfluss in der Fehlerleitung (26) als Fehler von einem an eine gemeinsame Fehlerleitung (26) angeschlossenen Verbraucher zu werten und ein entsprechendes Fehlersignal auszugeben und/oder abzuspeichern.

6. Verbund (10) nach einem der vorhergehenden Ansprüche, **dadurch gekennzeichnet, dass** das Bordnetzsteuergerät (12) dazu eingerichtet ist, eine Fehlerlampe (60) einzuschalten und/oder die Fehlermeldung an ein Fahrzeug-Infotainment-System zu übergeben und/oder die Fehlermeldung in einem auslesbaren Speicher abzuspeichern.

7. Verbund (10) nach einem der vorhergehenden Ansprüche, **dadurch gekennzeichnet, dass** wenigstens zwei Lichtsteuergeräte (14) und (16) an eine gemeinsame Fehlerleitung (26) angeschlossen sind.

8. Verbund (10) nach einem der Ansprüche 1 bis 7, **dadurch gekennzeichnet, dass** das Bordnetzsteuergerät (12) dazu eingerichtet ist, alle an eine gemeinsame Fehlerleitung (26) angeschlossenen Lichtsteuergeräte (14, 16) nacheinander abzuschalten und wieder einzuschalten, sodass jeweils nur ein einzelnes Lichtsteuergerät (14) oder (16) abgeschaltet ist.

9. Verbund (10) nach einem der Ansprüche 5, 7, **dadurch gekennzeichnet, dass** ein Widerstand eines Strompfades, der zwischen einem Masseanschluss (48) des ersten Lichtsteuergerätes (14) und einem Anschluss (62) des zweiten Lichtsteuergerätes (16) an die gemeinsame Fehlerleitung (26) liegt, einen anderen Wert besitzt als der Widerstand des Strompfades, der zwischen dem Masseanschluss (48) des zweiten Lichtsteuergerätes (16) und dem Anschluss (62) des zweiten Lichtsteuergerätes (16) an die gemeinsame Fehlerleitung (26) liegt.

10. Verbund (10) nach einem der Ansprüche, 1 - 4, 6, **dadurch gekennzeichnet, dass** das erste Lichtsteuergerät (14) und zweite Lichtsteuergerät (16) zusammen über eine gemeinsame Versorgungsleitung (66) an einen ersten Anschlusspin (20) des Bordnetzsteuergeräts (12) angeschlossen sind und dass das erste Lichtsteuergerät (14) über eine eigene Fehlerleitung (68) an einen zweiten Anschlusspin (24) des Bordnetzsteuergeräts (12) angeschlossen ist und dass das das zweite Lichtsteuergerät (16) über eine eigene Fehlerleitung (70) an einen dritten Anschluss (28) des Bordnetzsteuergeräts (12) angeschlossen ist.

## Claims

1. A combination (10) of an on-board power supply control device (12) and at least one light control device (14) that is arranged for operating at least one semiconductor light source (36, 38), and the on-board power supply control device (12) is arranged to be used for supplying current to the light control device (14) via a supply line (18) connected to a first connection pin (20) of the on-board power supply control device (12), for monitoring currents flowing via connection pins of the on-board power supply control device (12), and for diagnosing the power consumer connected to the respective connection pin, **characterized in that** the light control device (14) is additionally connected via a fault line (26) to a further connection pin (28) of the on-board power supply control device (12) and is arranged for monitoring the function of the connected semiconductor light source (36, 38) and, in the event of a fault function, of opening up a flow of current in the fault line (26), and the on-board power supply control device (12) is arranged for reacting to the opened-up flow of current by generating a fault report.

2. The combination (10) of claim 1, **characterized in that** each light control device (14, 16) is arranged for controlling at least one semiconductor light source (36, 38) .

3. The combination (10) of one of the foregoing claims, **characterized in that** each light control device (14, 16) has a protection and monitoring circuit (40, 42), which is arranged for detecting fault functions of the respective connected semiconductor light source (36, 38) and/or ensuring temperature protection and/or ensuring electromagnetic compatibility and/or reverse polarity protection.

4. The combination (10) of claim 3, **characterized in that** the protection and monitoring circuit (40) is arranged, if a fault function is detected, for closing a normally open switch (44), with which the fault line (26), when the switch (44) is closed, is connected to a ground connection (48).

5. The connection (10) of one of the foregoing claims, **characterized in that** the on-board power supply control device (12) is arranged, and in particular programmed, for evaluating a flow of current in the fault line (26) as a fault of one of the consumers connected to a common fault line (26) and for outputting a corresponding fault signal and/or storing it in memory.

6. The connection (10) of one of the foregoing claims, **characterized in that** the on-board power supply control device (12) is arranged for switching on a fault lamp (60) and/or forwarding the fault report to a vehicle infotainment system and/or storing the fault report in memory in a readable memory.

7. The connection (10) of one of the foregoing claims, **characterized in that** at least two light control devices (14) and (16) are connected to a common fault line (26).

8. The connection (10) of one of the claims 1 to 7, **characterized in that** the on-board power supply control device (12) is arranged for successively switching all the light control devices (14, 16) connected to a common fault line (26) off and back on again, so that only a single light control device (14) or (16) is switched off at a time.

9. The connection (10) of one of the claims 5, 7, **characterized in that** a resistance of a current path that is located between a ground connection (48) of the first light control device (14) and a connection (62) of the second light control device (16) to the common fault line (26), has a different value from the resistance of the current path that is located between the ground connection (48) of the second light control device (16) and the connection (62) of the second light control device (16) to the common fault line (26).

10. The connection (10) of one of the claims 1 - 4, 6, **characterized in that** the first light control device (14) and second light control device (16) are connected together, via a common supply line (66), to a first connection pin (20) of the on-board power supply control device (12); and that the first light control device (14) is connected via its own fault line (68) to a second connection pin (24) of the on-board power supply control device (12); and that the second light control device (16) is connected via its own fault line (70) to a third connection (28) of the on-board power supply control device (12).

## Revendications

1. Combiné (10) constitué d'un contrôleur de réseau de bord (12) et d'au moins un contrôleur d'éclairage (14) conçu pour faire fonctionner au moins une source de lumière à semiconducteur (36, 38), le contrôleur de réseau de bord (12) étant conçu pour alimenter électriquement le contrôleur d'éclairage (14) par le biais d'une ligne d'alimentation (18) raccordée à une première broche de raccordement (20) du contrôleur de réseau de bord (12) et pour surveiller les courants qui circulent par le biais de broches de raccordement du contrôleur de réseau de bord (12) et les utiliser pour le diagnostic du consommateur de courant raccordé à la broche de raccordement correspondante, **caractérisé en ce que** le contrôleur d'éclairage (14) est en plus raccordé par le biais d'une ligne de défaut (26) à une broche de raccordement supplémentaire (28) du contrôleur de réseau de bord (12) et il est conçu pour vérifier le fonctionnement de la source de lumière à semiconducteur (36, 38) raccordée et, dans le cas d'un défaut de fonctionnement, générer un flux de courant dans la ligne de défaut (26), et le contrôleur de réseau de bord (12) étant conçu pour réagir au flux de courant généré en produisant un message d'erreur.

2. Combiné (10) selon la revendication 1, **caractérisé en ce que** chaque contrôleur d'éclairage (14, 16) est conçu pour commander au moins une source de lumière à semiconducteur (36, 38).

3. Combiné (10) selon l'une des revendications précédentes, **caractérisé en ce que** chaque contrôleur d'éclairage (14, 16) présente un circuit de protection et de surveillance (40, 42) qui est conçu pour détecter les défauts de fonctionnement de la source de lumière à semiconducteur (36, 38) respectivement raccordée et/ou pour garantir une protection thermique et/ou pour garantir une compatibilité électromagnétique et/ou une protection contre les inversions de polarité.

4. Combiné (10) selon la revendication 3, **caractérisé en ce que** le circuit de protection et de surveillance (40, 42) est conçu pour, en présence d'un défaut de fonctionnement détecté, fermer un commutateur (44) normalement ouvert avec lequel la ligne de défaut (26) est reliée avec une borne de masse (48) lorsque le commutateur (44) est fermé.

5. Combiné (10) selon l'une des revendications précédentes, **caractérisé en ce que** le contrôleur de réseau de bord (12) est conçu, notamment programmé pour interpréter un flux de courant dans une ligne de défaut (26) comme étant un défaut de l'un des consommateurs raccordés à la ligne de défaut (26) commune et pour délivrer et/ou mettre en mémoire un signal de défaut correspondant.

6. Combiné (10) selon l'une des revendications précédentes, **caractérisé en ce que** le contrôleur de réseau de bord (12) est conçu pour allumer un témoin lumineux de défaut (60) et/ou transmettre le message d'erreur à un système d'info-divertissement du véhicule et/ou mettre en mémoire le message d'erreur dans une mémoire lisible.

7. Combiné (10) selon l'une des revendications précédentes, **caractérisé en ce qu'**au moins deux contrôleurs d'éclairage (14) et (16) sont raccordés à une ligne de défaut (26) commune.

8. Combiné (10) selon l'une des revendications 1 à 7, **caractérisé en ce que** le contrôleur de réseau de bord (12) est conçu pour mette hors circuit et à remettre en circuit l'un après l'autre tous les contrôleurs d'éclairage (14, 16) raccordés à une ligne de défaut (26) commune de telle sorte qu'un seul contrôleur d'éclairage (14) ou (16) soit à chaque fois mis hors circuit.

9. Combiné (10) selon l'une des revendications 5, 7, **caractérisé en ce qu'**une résistance d'un chemin de courant qui se trouve sur la ligne de défaut (26) commune entre une borne de masse (48) du premier contrôleur d'éclairage (14) et une borne (62) du deuxième contrôleur d'éclairage (16) possède une autre valeur que la résistance du chemin de courant qui se trouve sur la ligne de défaut (26) commune entre la borne de masse (48) du deuxième contrôleur d'éclairage (16) et la borne (62) du deuxième contrôleur d'éclairage (16).

10. Combiné (10) selon l'une des revendications 1 - 4, 6, **caractérisé en ce que** le premier contrôleur d'éclairage (14) et le deuxième contrôleur d'éclairage (16) sont raccordés ensemble par le biais d'une ligne d'alimentation (66) commune à une première broche de raccordement (20) du contrôleur de réseau de bord (12) et **en ce que** le premier contrôleur d'éclairage (14) est raccordé par le biais d'une ligne de défaut propre (68) à une deuxième broche de raccordement (24) du contrôleur de réseau de bord (12) et **en ce que** le deuxième contrôleur d'éclairage (16) est raccordé par le biais d'une ligne de défaut propre (70) à une troisième broche de raccordement (28) du contrôleur de réseau de bord (12).
